# EUROPEAN PATENT APPLICATION

(11) **EP 2 472 276 A2**
(43) Date of publication of application: **04.07.2012**
(21) Application number: 09768717.2
(22) Date of filing: 26.08.2009
(51) Int. Cl.: G01R 31/36

(54) **BATTERY POLARITY DETECTING SYSTEM**

(71) Applicant: Chang, I-Chang, Taiwan (CN)
(72) Inventor: Chang, I-Chang, Taiwan (CN)
(74) Representative: Horak, Michael
(86) International application number: PCT/CN2009/000974
(87) International publication number: WO 2009/155792

(57) **Abstract**

The battery polarity detection system contains multiple detection terminals (2), a control unit (5), and a charging/discharging circuit (8). Each detection terminal (2) is connected to a terminal of a battery (1). The control unit (5) has an internal default voltage and is capable of measuring voltage differences between the detection terminals (2) and comparing the voltage differences with the internal default voltage. If a voltage difference between a first detection terminal and a second detection terminal is greater than the internal default voltage, the control unit (5) makes the first detection terminal of a greater voltage connected to a positive terminal of the charging/discharging circuit (8); and the control unit (5) makes the second detection terminal of zero voltage connected to a negative terminal of the charging/discharging circuit (8), thereby forming a complete loop. The battery polarity detection system can avoid burning down the battery's control or password IC.

## Description

### (a) Technical Field of the Invention

The present invention is generally related to a battery polarity detection system and method, and more particular to battery polarity detection system capable identifying a battery's polarity so as to prevent the battery's control IC is burned down due to polarity misjudgment.

### (b) Description of the Prior Art

Consumer electronic appliances (e.g., cellular phones, digital cameras, MP3 players, etc.) are widely popular and these appliances are usually powered by a rechargeable battery. The battery charger therefore becomes a basic accessory.

As the appliances compete fiercely with their unique and appealing shapes and colors, the rechargeable batteries used are usually specially designed and their chargers are therefore not compatible.

As such, there are so-called universal chargers that can be used to charge batteries of different sizes, specification, terminals, and polarities. The chargers need to detect the correct polarity of the batteries and the power is then correctly applied to charge the batteries.

These conventional chargers have the following disadvantage.

Some of the lithium batteries have their terminals equipped with control IC or password IC (C pin). For these terminals, no positive or negative power should be applied. Otherwise, the control or password IC then could be burned down.

### SUMMARY OF THE NTION

Therefore, a battery polarity detection system is provided herein so as to obviate the problem of burning down the control or password IC of a battery due to misjudgment of the battery's terminals.

To achieve the objective, the battery polarity detection system contains multiple detection terminals, each connected to a terminal of a battery; a control unit having an internal default voltage capable of measuring voltage differences between the detection terminals and comparing the voltage differences with the internal default voltage; and a charging/discharging circuit. If a voltage difference between a first detection terminal and a second detection terminal is greater than the internal default voltage, the control unit makes said first detection terminal of a greater voltage connected to a positive terminal of the charging/discharging circuit; and the control unit makes the second detection terminal of zero voltage connected to a negative terminal of the charging/discharging circuit, thereby forming a complete loop.

Since a conduction terminal with control or password IC cannot be applied with any power, therefore to prevent burning down the control or password IC, the battery polarity detection system correctly avoid the conduction terminal with control or password IC. The control unit is equipped with an internal default voltage. If a terminal of the battery has a voltage greater than the internal default voltage, the terminal is considered as a positive terminal of the battery. If there is more than one terminal, the one with the greatest voltage is identified as the positive terminal of the battery. The control unit then conducts the terminal with a positive terminal of the charging/discharging circuit. As to a terminal with zero voltage, the control unit makes the terminal conducted to a negative terminal of the charging/discharging circuit, thereby forming a complete loop. As such the terminals with control or password IC are avoided.

A secondary objective of the present invention is to provide a method of detecting a battery's polarity.

To achieve the objective, the method connects one or more detection terminals to the terminals of a battery under test. Then, the method compared the voltages measured from the detection terminals with an internal default voltage. If a terminal of the battery has a voltage greater than the internal default voltage and is the greatest voltage, the terminal is identified as the positive terminal of the battery. The method then conducts the terminal with a positive terminal of a charging/discharging circuit so as to form a complete loop.

Since a conduction terminal with control or password IC cannot be applied with any power, therefore to prevent burning down the control or password IC, the battery polarity detection system correctly avoid the conduction terminal with control or password IC. The control unit is equipped with an internal default voltage. If a terminal of the battery has a voltage greater than the internal default voltage and is the greatest voltage, the terminal is identified as the positive terminal of the battery. As to a terminal with zero voltage, the terminal is considers as a negative terminal of the battery. As such the battery's positive and negative terminals can be successfully identified and the terminals with control or password IC are avoided.

The benefit of the present invention lies in the battery's polarity can be correctly identified and the control or password IC can be prevented from burning down.

The foregoing objectives and summary provide only a brief introduction to the present invention. To fully appreciate these and other objects of the present invention as well as the invention itself, all of which will become apparent to those skilled in the art, the following detailed description of the invention and the claims should be read in conjunction with the accompanying drawings. Throughout the specification and drawings identical reference numerals refer to identical or similar parts.

Many other advantages and features of the present invention will become manifest to those versed in the art upon making reference to the detailed description and the accompanying sheets of drawings in which a preferred structural embodiment incorporating the principles of the present invention is shown by way of illustrative example.

### BRIEF DESCRIPTION OF THE DRAWINGS

FIG 1 is a functional block diagram showing a battery polarity detection system according a first embodiment of the present invention.
FIG 2 is a circuit diagram of FIG 1.
FIG 3 is a functional block diagram showing a battery polarity detection system according a second embodiment of the present invention.
FIG 4 is a circuit diagram of FIG 3.
FIG 5 is a flow diagram showing the steps of the battery polarity detection system in detecting the polarity of a battery.

### DETAILED DESCRIPTION OF THE PREFERRED EMBODIMENTS

The following descriptions are exemplary embodiments only, and are not intended to limit the scope, applicability or configuration of the invention in any way. Rather, the following description provides a convenient illustration for implementing exemplary embodiments of the invention. Various changes to the described embodiments may be made in the function and arrangement of the elements described without departing from the scope of the invention as set forth in the appended claims.

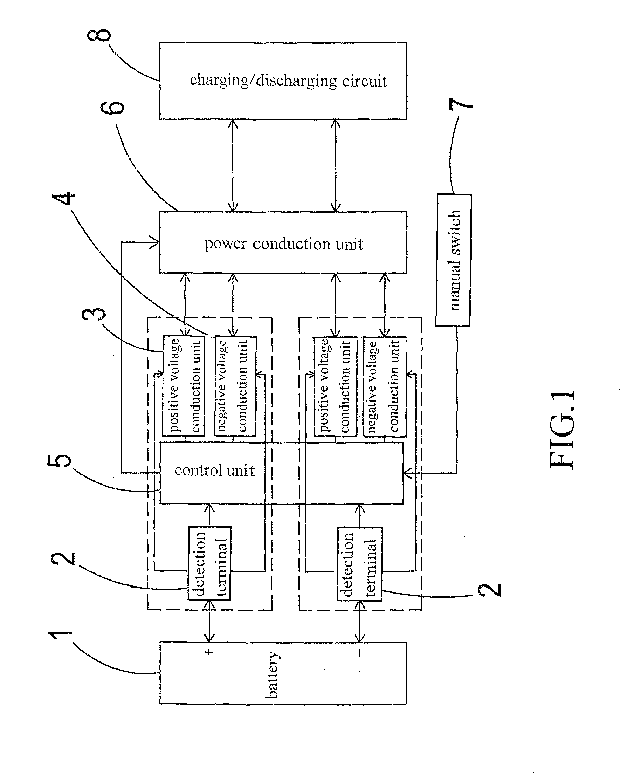

As illustrated in FIG 1, a polarity detection system for a battery according to a first embodiment of the present invention contains the following components.

There are two detection terminals 2 connected to the two terminals of a battery 1 under test, respectively. Each detection terminal 2 is connected to a positive voltage conduction unit 3 and a negative voltage conduction unit 4 of the battery polarity detection system.

There is a control unit 5 which is connected to the two detection terminals 2, the positive voltage conduction units 3, and the negative voltage conduction units 4. The control unit 5 is capable of measuring the voltages at the two detection terminals 2 and comparing the voltage difference against an internal default voltage of the control unit 5.

There is a power conduction unit 6 which is connected to the control unit 5, a charging/discharging circuit 8, the positive voltage conduction units 3 and the negative voltage conduction units 4. When the control unit 5 detects that the voltage difference measured across the detection terminals 2 is greater than its default voltage, the control unit 5 enables the following scenario: the positive voltage conduction unit 3 connected to the detection terminal 2 with a highest voltage level is conducted, the negative voltage conduction unit 4 connected to the detection terminal 2 with a zero voltage level is conducted, and the power conduction unit 6 is conducted.

There is a manual switch 7 which is connected to the control unit 5.

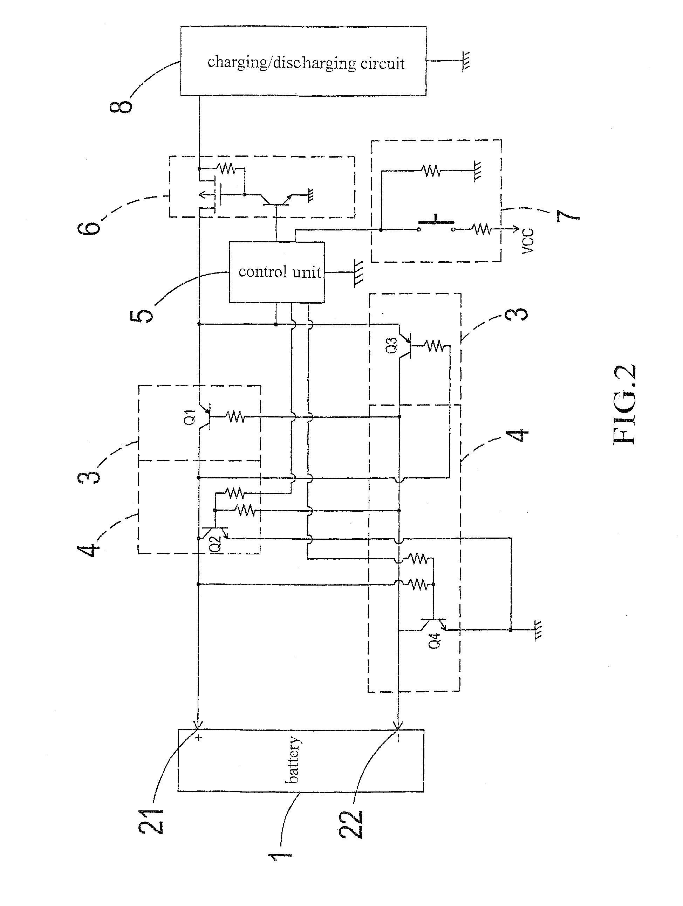

The operation of the battery polarity detection system is as follows. As further shown in FIG 2 which is a circuit diagram for FIG 1, the two detection terminals 21 and 22 (i.e., the detection terminals 2 of FIG 1) are connected to the battery 1. If the detection terminal 21 is connected to the positive terminal of the battery 1, the detection terminal 22 is connected to the negative terminal of the battery 1, and the voltage difference is greater than the default voltage of the control unit 5, the power conduction unit 6 is conducted, the positive voltage at the detection terminal 21 makes the transistor Q4 (i.e., the negative voltage conduction unit 4) conducted, and the detection terminal 22 is conducted to the ground of the power conduction unit 6. The negative voltage at the detection terminal 22 makes the transistor Q1 (i.e., the positive voltage conduction unit 3) conducted, and the detection terminal 21 is conducted to the positive voltage of the power conduction unit 6. On the other hand, if the detection terminal 21 is connected to the negative terminal of the battery 1 and the detection terminal 22 is connected to the positive terminal of the battery 1, the negative voltage at the detection terminal 21 makes the transistor Q3 conducted, and the detection terminal 22 is conducted to the positive voltage of the power conduction unit 6. In the meantime, the positive voltage at the detection terminal 22makes the transistor Q2 conducted, the detection terminal 21 is conducted to the ground of the power conduction unit 6, and a complete loop is formed between the charging/discharging circuit 8 and the battery 1.

As some battery 1 has over-discharging protection so that, when the voltage of the battery 1 drops to a threshold (e.g., 2.5V), the battery 1 will stop discharging, and the battery 1 can only be trigger-charged. To solve this problem, the manual switch 7 can be turned on when the battery 1 is already over-discharged. After the manual switch 7 is turned on, the control unit 5 turns on the power conduction unit 6 and cross-connects the positive voltage conduction units 3 and the negative voltage conduction units 4 of the detection terminals 2 so that positive and negative voltages are alternately switched between the detection terminals 2. The over-discharged battery 1 as such can be charged again.

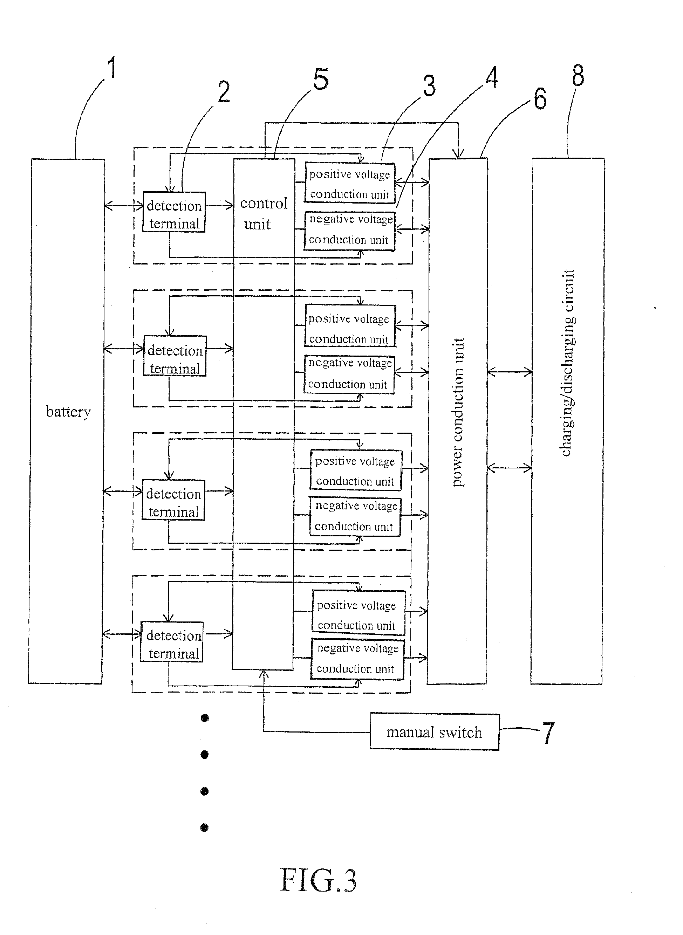

FIG 3 shows a polarity detection system for a battery according to a second embodiment of the present invention. As illustrated, the battery polarity detection system contains the following components.

There are four detection terminals 2 connected to a battery 1 under test. Each detection terminal 2 is connected to a positive voltage conduction unit 3 and a negative voltage conduction unit 4 of the battery polarity detection system.

There is a control unit 5 which is connected to the four detection terminals 2, the positive voltage conduction units 3, and the negative voltage conduction units 4. The control unit 5 is capable of measuring voltage differences across the detection terminals 2 and comparing the voltage differences against an internal default voltage of the control unit 5.

There is a power conduction unit 6 which is connected to the control unit 5, a charging/discharging circuit 8, the positive voltage conduction units 3 and the negative voltage conduction units 4. When the control unit 5 detects that a voltage difference measured across the detection terminals 2 is greater than its default voltage, the control unit 5 enables the following scenario: the positive voltage conduction unit 3 connected to the detection terminal 2 with a highest voltage level is conducted, the negative voltage conduction unit 4 connected to the detection terminal 2 with a zero voltage level is conducted, and the power conduction unit 6 is conducted so as to form a complete loop.

There is a manual switch 7 which is connected to the control unit 5.

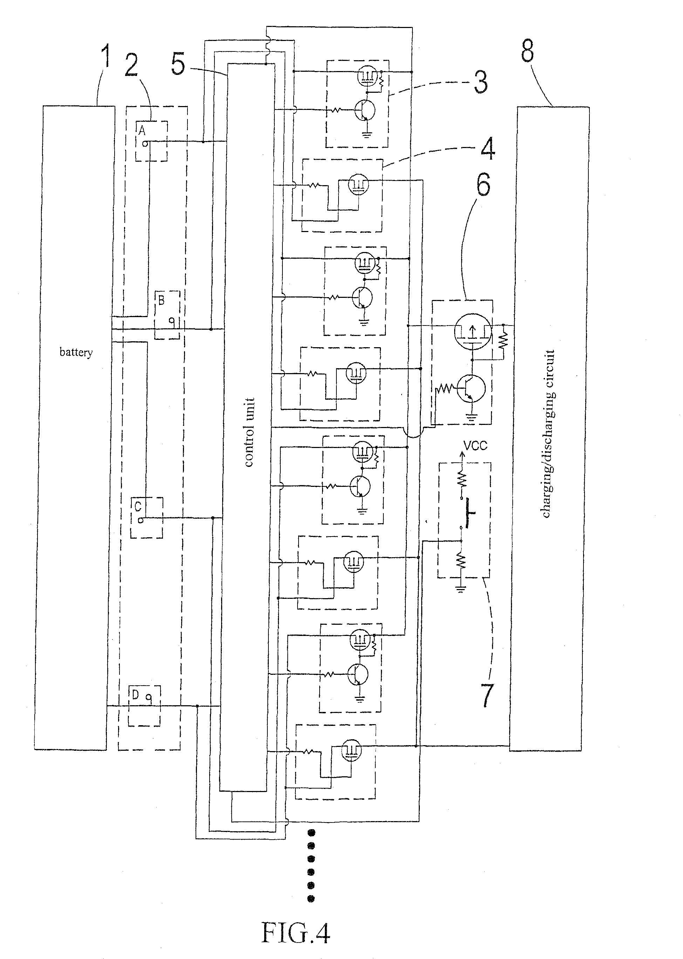

The operation of the battery polarity detection system is as follows. As further shown in FIG 4 which is a circuit diagram for FIG 3, there are four detection terminals 2 in the present embodiment and in alternative embodiments there can be 3, 5, or 6 detection terminals. The number of detection terminals 2 is not restricted to a particular number. The detection terminals are connected to the battery 1 for polarity detection.

The control unit 5 has an internal default voltage (e.g., 2.5V). When the voltage differences measured by the control unit 5 is not greater than the default voltage, none of the detection terminals 2 has correctly connected to the positive terminal of the battery 1, and any charging operation is stopped. The detection terminals 2 then can be re-connected to the proper terminals of the battery 1. If there is control IC or password IC inside and connected to the conduction terminal of the battery 1, a voltage drop would be induced across the IC and the measured voltage difference by the control unit 5 cannot exceed the default voltage. As such, the conduction terminal will not be mistakenly considered as the positive terminal of the battery 1.

On the other hand, when the voltage differences measured by the control unit 5 is greater than the default voltage, one of the detection terminals 2 which is detected to have the highest voltage has correctly connected to the positive terminal of the battery 1. The detection terminal 2's positive voltage conduction unit 3 and the power detection unit 6 are conducted. Then the detection terminal 2 with zero detected voltage is connected to the negative terminal of the battery 1 and its negative voltage conduction unit 4 is conducted. The rest of the terminals of the battery 1 then can be the conduction terminal for the control IC or the password IC, which cannot be connected to positive or negative power.

As some battery 1 has over-discharging protection so that, when the voltage of the battery 1 drops to a threshold (e.g., 2.5V), the battery 1 will stop discharging, and the battery 1 can only be trigger-charged. To solve this problem, the manual switch 7 can be turned on when the battery 1 is already over-discharged. After the manual switch 7 is turned on, the control unit 5 turns on the power conduction unit 6 and cross-connects the positive voltage conduction units 3 and the negative voltage conduction units 4 of the detection terminals 2 so that positive and negative voltages are alternately switched between two detection terminals 2. The over-discharged battery 1 as such can be charged again.

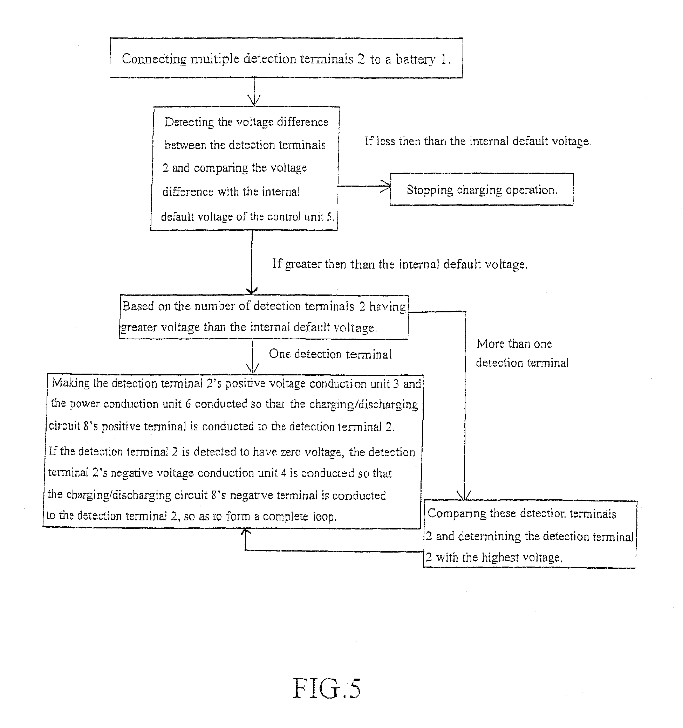

FIG 5 provides a flow diagram showing the steps of the battery polarity detection system in detecting the polarity of the battery 1 as follows.

Multiple detection terminals 2 are connected to a battery 1. The control unit 5 detects the voltage difference between the detection terminals 2 and compares the voltage difference with the internal default voltage of the control unit 5. If a voltage difference is greater than the default voltage and there is only one detection terminal 2 having the greater voltage, the detection terminal 2's positive voltage conduction unit 3 and the power conduction unit 6 are conducted so that the charging/discharging circuit 8's positive terminal is conducted to the detection terminal 2. If a detection terminal 2 is detected to have zero voltage, the detection terminal 2's negative voltage conduction unit 4 is conducted so that the charging/discharging circuit 8's negative terminal is conducted to the detection terminal 2. If there are more than one detection terminals 2 having a greater-than-default voltage, these detection terminals 2 are compared and the one with the highest voltage is determined. Its positive voltage conduction unit 3 and the power conduction unit 6 are conducted so that the positive terminal of the charging/discharging circuit 8 is conducted to the detection terminal 2. If a detection terminal 2 is detected to have zero voltage, the detection terminal 2's negative voltage conduction unit 4 is conducted so that the charging/discharging circuit 8's negative terminal is conducted to the detection terminal 2 and a complete loop is formed.

Therefore, the advantage of the battery polarity detection system over the prior art is as follows.

The battery polarity detection system has a control unit 5 with an internal default voltage. The control unit 5 detects the voltage differences between the detection terminals 2 and compares the voltage differences with the internal default voltage of the control unit 5. If there are more than one detection terminals 2 having a greater-than-default voltage, these detection terminals 2 are compared and the one with the highest voltage is determined. Its positive voltage conduction unit 3 and the power conduction unit 6 are conducted so that the positive terminal of the charging/discharging circuit 8 is conducted to the detection terminal 2. If a detection terminal 2 is detected to have zero voltage, the detection terminal 2's negative voltage conduction unit 4 is conducted so that the charging/discharging circuit 8's negative terminal is conducted to the detection terminal 2 and a complete loop is formed. If the battery 1 under test has a conduction terminal with control IC or password IC, the detection terminal 2 having the highest, greater-than-default voltage is identified as being connected correctly to the positive terminal of the battery 1 (and its positive voltage conduction unit 3 is conducted), the detection terminal 2 having zero voltage is identified as being connected correctly to the negative terminal of the battery 1 (and its negative voltage conduction unit 4 is conducted), the rest of the detection terminals are considered to be connected probably to the conduction terminals with control IC or password IC. These detection terminals 2's positive and negative voltage conduction units 3 and 4 are not conducted.

While certain novel features of this invention have been shown and described and are pointed out in the annexed claim, it is not intended to be limited to the details above, since it will be understood that various omissions, modifications, substitutions and changes in the forms and details of the device illustrated and in its operation can be made by those skilled in the art without departing in any way from the spirit of the present invention.

## Claims

1. A battery polarity detection system, comprising:
a plurality of detection terminals (2), each connected to a terminal of a battery (1);
a control unit (5) having an internal default voltage, said control unit (5) capable of measuring voltage differences between said detection terminals (2) and comparing said voltage differences with said internal default voltage; and
a charging/discharging circuit (8);
wherein, if a voltage difference between a first detection terminal and a second detection terminal is greater than said internal default voltage, said control unit (5) makes said first detection terminal of a greater voltage connected to a positive terminal of said charging/discharging circuit (8); and said control unit (5) makes said second detection terminal of zero voltage connected to a negative terminal of said charging/discharging circuit (8), thereby forming a complete loop.

2. The battery polarity detection system according to claim 1, further comprising:
a plurality of positive voltage conduction units (3), each connected to one of said detection terminals (2) and said control unit (5);
a plurality of negative voltage conduction units (4), each connected to one of said detection terminals (2) and said control unit (5); and
a power conduction unit (6) connected to said charging/discharging circuit (8);
wherein, for said detection terminals (2) having a voltage greater than said internal default voltage, said positive voltage detection unit (3) of a detection terminal (2) having the highest voltage and said power conduction unit (6) are conduced so that said detection terminal (2) is conducted to said positive terminal of said charging/discharging circuit (8); and, for a detection terminals (2) having zero voltage, said negative voltage conduction unit (4) of said detection terminal (2) is conducted so that said detection terminal is conducted to said negative terminal of said charging/discharging circuit (8) and a complete loop is formed.

3. The battery polarity detection system according to claim 2, wherein said power conduction unit (6) is connected to said control unit (5), and all of said positive and negative voltage conduction units (3, 4).

4. The battery polarity detection system according to claim 3, wherein, when a voltage difference is greater than said internal default voltage, said control unit (5) makes said power conduction unit (6) conducted.

5. The battery polarity detection system according to claim 1, further comprising a manual switch (7) connected to said control unit (5); wherein, when a battery (1) under test is over-discharged and after said manual switch (7) is turned on, said control unit (5) turns on said power conduction unit (6) and cross-connects said positive voltage conduction units (3) and said negative voltage conduction units (4) so that positive and negative voltages are alternately switched between said detection terminals (2) and said over-discharged battery (1) as such is charged again.

6. The battery polarity detection system according to claim 1, wherein said control unit (5) is capable of comparing a positive terminal of a battery loop connected to a detection terminal (2) with said internal default voltage; if a voltage measured at said positive terminal of said battery loop is greater than said internal default voltage, said detection terminal (2) is conducted to a positive terminal of said charging/discharging circuit (8); and if a zero voltage is measured, said detection terminal (2) is conducted to a negative terminal of said charging/discharging circuit (8) so as to form a loop.
